(19) Europäisches Patentamt
European Patent Office
Office européen des brevets

(11) Publication number: 0 077 057 B2

(12) **NEW EUROPEAN PATENT SPECIFICATION**

(45) Date of publication of the new patent specification: **16.08.89**

(51) Int. Cl.⁴: **G 03 F 7/10**, C 08 F 8/28

(21) Application number: **82109354.9**

(22) Date of filing: **08.10.82**

(54) **Negative-type resist sensitive to ionizing radiation.**

(30) Priority: **09.10.81 JP 161430/81**
**03.09.82 JP 152645/82**

(43) Date of publication of application:
**20.04.83 Bulletin 83/16**

(45) Publication of the grant of the patent:
**16.04.86 Bulletin 86/16**

(45) Mention of the opposition decision:
**16.08.89 Bulletin 89/33**

(84) Designated Contracting States:
**DE FR GB**

(56) References cited:
**DE-A- 2 130 283**
**DE-A- 2 231 815**
**DE-A- 2 725 308**
**DE-A- 3 135 804**
**US-A- 2 929 710**
**US-A- 3 867 147**
**US-A- 4 259 407**

**CHEMICAL ABSTRACTS, vol. 82, no. 22, June 2, 1975, abstract no. 148529t, page 586, Columbus Ohio (US)**
**CHEMICAL ABSTRACTS, vol. 88, no. 26, June 26, 1978, abstract no. 192939z, page 100, Columbus Ohio (US)**
**JOURNAL OF THE ELECTROCHEMICAL SOCIETY, vol. 116, no. 7, July 1969, The Electrochemical Society Inc., Princeton N.Y. (US) H.Y. KU et al.: "Polymeric Electron Beam Resists", pages 980-985**

(73) Proprietor: **DAI NIPPON INSATSU KABUSHIKI KAISHA, 1-1, Kaga-Cho 1-Chome Ichigaya Shinjuku-Ku, Tokyo 162 (JP)**

(72) Inventor: **Ogata, Naoya, 21-12, Tsuhishi 2-Chome, Kamakura-Shi Kanagawa-Ken (JP)**
Inventor: **Sanui, Kohei, 29-8, Wakabayashi 4-Chome, Setagaya-Ku Tokyo-To (JP)**
Inventor: **Azuma, Chiaki, 920-104, Mogusa, Hino-Shi Tokyo-To (JP)**
Inventor: **Tanaka, Hozumi, 1-1-507, Gyoda Danchi 15-2, Gyoda-Cho, Funabashi-Shi Chiba-Ken (JP)**
Inventor: **Oguchi, Kiyoshi, 252-2, Mizuno, Sayama-Shi Saitama-Ken (JP)**
Inventor: **Takahashi, Yoichi, 5-302, 7-20-16, Ryoke Urawa-Shi, Saitama-Ken (JP)**
Inventor: **Nakada, Tomihiro, 1708, Jyosui-Hon-Cho, Kodaira-Shi Tokyo-To (JP)**

(74) Representative: **Behn, Klaus, Dipl.-Ing., Patentanwalt Lindenberg 34, D-8134 Pöcking bei München (DE)**

EP 0 077 057 B2

## Description

This invention relates to a resist material suitable for fine pattern formation to be used in the lithographic process during manufacture of a high-density circuit such as LSI or ultra LSI, etc., or a photomask useful for production thereof. More particularly, it pertains to a novel negative-type resist material which has a high sensitivity and a high resolving power with respect to ionizing radiation and can produce a resist film of excellent etching resistance after hardening.

As is well known in the art, the demand for higher performance as well as higher degree of integration of semiconductor integrated circuits is ever increasing in recent years. For this reason, as a lithographic technique, in place of the photolithography employing ultra-violet rays of the prior art, efforts have been made to establish an ultrafine pattern working technique by the use of ionizing radiation of higher energy with shorter wavelength, namely, an electron beam, soft X-rays, an ion beam, etc.

On the other hand, for enabling an ultra-fine lithography by such a change of radiation source, the resist material to be used must have corresponding characteristics. Generally speaking, the resist material to be used in ultra-fine lithography with the use of a high energy ionizing radiation is required to have the following characteristics:

a) High sensitivity to the ionizing radiation;
b) High resolving power;
c) Capability of forming a uniform thin film;
d) Excellent resistance to dry etching so that dry etching which is essential for high density micropatternization may be applicable; and
e) Excellent developing characteristics.

In the prior art, a great number of resists sensitive to ionizing radiations have been developed to be used for the above purpose. These resists may be classified into the positive-type in which the irradiated portion disintegrates to be solubilized by irradiation of an ionizing radiation and the negative-type in which the irradiated portion undergoes crosslinking to be insolubilized by irradiation of an ionizing radiation.

Of these, the positive-type resists entail difficulty in selection of developers because generally a narrow scope of developers has characteristics adapted therefore and also suffer from the drawback of weak resistance to dry etching. In contrast, most of the negative-type resists are superior in these respects to the positive-type ones.

Representative of the negative-type resists developed in the prior art are the polyglycidyl methacrylate type, glycidyl methacrylate-ethyl acrylate copolymer type, and unsaturated carboxylic acid-methacrylate copolymer type. However, these negative-type resists have some drawbacks in practical application and cannot be said to be satisfactory. For example, a glycidyl methacrylate type resist, while having high sensitivity, has a low resolution, practically as low as only about 2.0 μm, due to generation of a large amount of scum at the brim portions of the drawn image pattern. Moreover, each of the above resists has low dry etching resistance (with too much or too fast reduction in film thickness during dry etching) and therefore has a disadvantage in that it is difficult to apply thereto a dry etching process, which is indispensable for high-density micropatternization.

In view of the state of the art as described above, an object of the present invention is to provide a novel negative-type resist sensitive to ionizing radiation which has high sensitivity and excellent dry etching resistance and is also capable of attaining a high degree of resolution.

Thus, the present invention, according to claim 1, provides a negative-type non-photosensitive resist sensitive to high energy ionizing radiation which comprises an acetalized polyvinyl alcohol polymer having a molecular weight of 10000 to 1000000 represented by the formula:

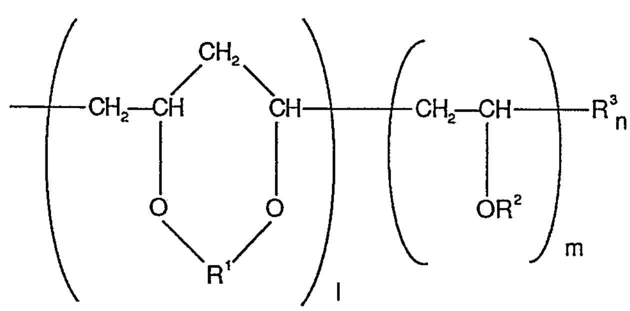

wherein $R^1$ represents a residue of an aldehyde or a ketone; $R^2$ a hydrogen atom, which may be partially substituted by an acetyl group; $R^3$ naught or a monomeric unit copolymerizable with vinyl acetate; l, m, n integers indicating polymerization degrees, the resist being developed with a solvent selected from aromatic hydrocarbons, chlorinated hydrocarbons, cellosolves, lower alcohols and mixtures thereof.

The acetalized polyvinyl alcohol polymer constituting the resist of the present invention is known as to its structure or preparation method per se, for example, as a modified vinylon or its preparation method. However, utilization as a

crosslinked resin thereof, especially for providing a resist film of excellent dry etching resistance by crosslinking by irradiation of an ionizing radiation is not known.

The present invention, according to claim 9, provides a high energy ionizing radiation lithographic method in which the above mentioned resist of the invention is used.

The nature, utility, and further features of this invention will be more clearly apparent from the following detailed description beginning with a consideration of general aspects of the invention and concluding with specific examples of practice thereof.

The terms '%' and 'part' used hereinafter in connection with compositions are by weight unless otherwise specified.

The group $R^1$ included in the acetalized moiety in the acetalized polyvinyl alcohol polymer represented by the above formula is a residue derived from an aldehyde or ketone during acetalization occurring between the aldehyde or ketone and an alcohol. Thus, the term 'acetalization' mentioned in the present specification is intended to be inclusive also of dehydrating condensation between a ketone and an alcohol (so called ketal formation) in addition to the acetalization in the narrow sense of dehydrating condensation between an aldehyde and an alcohol.

Typical examples of such a group $R^1$ may include aliphatic hydrocarbon groups derived from an aldehyde such as

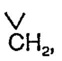 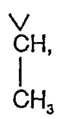 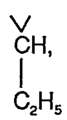 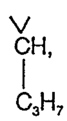

and also aromatic hydrocarbon groups such as

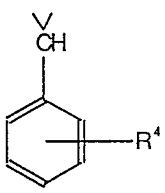

(wherein $R^4$ is hydrogen or a substituent other than hydrogen). Examples of the group $R^1$ derived from a ketone include the above mentioned groups derived from an aldehyde in which the hydrogen attached to the carbon participating in the ether bonding is replaced by a mono-valent aliphatic hydrocarbon or by a substituted or unsubstituted aromatic group, and a group derived from a cyclic ketone of the following formula:

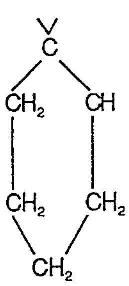

Among these, in order to obtain a resist film, it is preferred to use a group including cyclic structure, especially an aromatic ring.

Also, in order to obtain a high sensitivity, $R^1$ preferably contains a halogen.

As an example of such halogen-containing groups, there is the following group derived from a halogenated cyclohexanone:

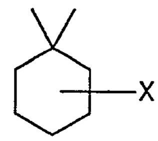

wherein X is a halogen.

In addition, when the halogen-containing groups $R^1$ derived from an aldehyde are represented comprehensively by the formula:

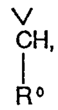

$R^0$ may include the following: as the aliphatic type:

$-CX_3$, $-CH_2X$, $-(CH_2)_4X$, etc.

as the aromatic type:

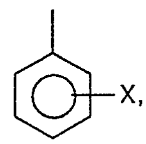 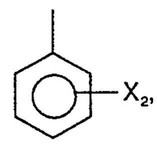 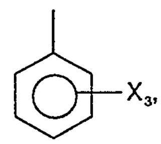

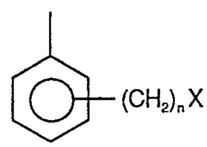 (n = 1,2, . . . . . ),

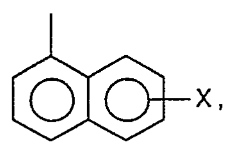

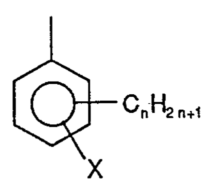 (n = 1,2, . . . . . ), etc.

as the heterocyclic type:

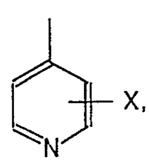 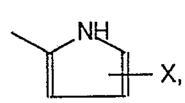 etc.

The halogen species may be any of F, Cl, Br, I, but is preferably Cl because of high sensitivity, and a mono-halogen-containing group is preferred. In particular, a group obtained by nucleus-substitution of a single halogen for a hydrogen in a mono-benzene ring is preferred. As the position of the mono-halogen substituent, metha- or para-position is preferred.

Preparation of the above acetalized polyvinyl alohol polymer can be carried out according to a known reaction. Thus, as briefly referred to in the description of the above group $R^1$, it can be obtained by acetalization of polyvinyl alcohol with an aldehyde or a ketone in a homogeneous system or an inhomogeneous system, in the presence of, for example, an acid such as hydrochloric acid or sulfuric acid or a salt thereof. Alternatively, the acetalized polyvinyl alcohol polymer can also be obtained from polyvinyl acetate or a partially saponified product thereof as the starting material, by allowing deacetylation and acetalization to proceed simultaneously in a similar system. Further, it is also possible to carry out acetalization between an aldehyde or a ketone and a copolymer of vinyl acetate with a monomer copolymerizable with vinyl acetate such as ethylene or styrene in place of polyvinyl alcohol or polyvinyl acetate.

Thus, an acetalized polyvinyl alcohol polymer as represented by the above formula can be obtained.

As can be understood from the above description, groups represented by $R^2$ are ordinarily H (hydrogens), but a part of them may be an acetyl group ($CH_3CO$) derived from polyvinyl acetate. The group $R^3$ represents naught or polymeric units of ethylene, styrene, etc. Also, as is apparent from the preparation steps, the acetalized polyvinyl alcohol polymer is generally a random copolymer, and the expression by the above formula does not necessarily mean the bonding mode of a block copolymer.

The acetalized polyvinyl alcohol polymer as a whole has a molecular weight in the range of from 10000 to 1000000. In general, the sensitivity becomes higher as the molecular weight increases, but the coating characteristics are impaired at an excessively high molecular weight. For affording suitable characteristics as an ionization radiation resist such as desirable sensitivity and etching resistance, the mole content of the acetalized moiety, namely $l/(l+m+n)$ is preferably 20 to 85%, particularly 20 to 80%. When the vinyl alcohol polymer units are represented by $m_1$ and the vinyl acetate polymer units by $m_2$ ($m_1+m_2=m$), the vinyl alcohol polymer units content, namely $m_1/(l+m+n)$ ist preferably 10 to 70 mole%, the vinyl acetate polymer units content, namely, $m_2/(l+m+n)$, being 40 mole% or less, the other polymeric units content, namely, $n/(l+m+n)$, being 20 mole% or less.

The resist of the present invention is preferably constituted by the above acetalized polyvinyl alcohol polymer alone, but it may also be constituted, if desired, by a mixture of the polymer with other polymers highly compatible with the polymer and having good solubility in solvents. Examples of such polymers include polyvinyl acetate, polyvinyl alcohol (inclusive of partially saponified polyvinyl alcohol (inclusive of acetate), ethylene/vinyl acetate copolymer and partially saponified products thereof, and styrene/vinyl acetate copolymer and partially saponified products thereof. When used as a mixture, the acetalized polyvinyl alcohol polymer represented by the above formula is used preferably in a proportion of 50% by weight or more based on the total weight with the other polymers.

Now, the lithographic process with the use of the resist of the present invention will be described below.

First, the resist of the present invention is dissolved in one or a mixture of solvents selected from aromatic solvents such as benzene, xylene, and chlorobenzene; ketone type solvents such as acetone and methyl ethyl ketone; chlorine-containing solvents such as chloroform and ethylene chloride; and cellosolve type solvents such as methyl cellosolve, ethyl cellosolve, and ethyl cellosolve acetate, to prepare about 5 to 15% solution having a viscosity suitable for coating.

The resist solution is applied uniformly in a conventional manner by spinner coating, etc. on a semiconductor substrate or a mask substrate (blank) to be treated. Examples of appropriate semiconductor substrate include silicon substrates optionally covered with a thin layer of silicon dioxide, silicon nitride, polysilicon or aluminum. Examples of appropriate mask substrates (blanks) include a single-layer chromium (Cr) mask blank, two- or three-layer chromium mask-blank with one or both surfaces of low reflection, see-through type mask blank comprising (i) a compound of silicon and silicon oxide or (ii) ferric oxide, single layer tantalum (Ta) mask blank, and two- or three-layer tantalum mask blank with low surface reflection and conductive mask blanks comprising an additional transparent electroconductive layer along with the above mentioned masking layers (such as Cr, Ta and silicon compound layers).

The thus coated substrate is then subjected to a pre-bake treatment, to form a resist film of a thickness of about 0.1-2 µm. The pre-bake conditions differ depending on the solvent employed. In general, a temperature of 70-90°C and a time of 20 to 40 minutes are suitable in case of lower alcohols.

Subsequently, at the desired portions of the resist film, an ionizing radiation such as an electron beam or soft X-ray is applied to accomplish pattern drawing, followed further by treatment with a developer to dissolve away selectively the unirradiated portions, thereby forming & resist pattern. As the developer, solvents similar to those used for preparation of resist solutions as described above are preferably employed. The thus formed resist pattern is preferably rinsed, for example, with a lower alcohol.

The substrate having the resist pattern after

development may be subjected to post-bake treatment and scum elimination treatment, as desired, and thereafter subjected to etching to form an etching pattern at the exposed portion of the substrate. The post-bake treatment may be conducted, for example, at a temperature of 120-140 °C for 20-40 minutes. On the other hand, the scum elimination treatment can be conducted, for example, with the use of an oxygen plasma under the conditions of a pressure of 120-133 Pa (0.9-1 Torr) and an output of 100 W for 1-2 minutes.

For etching, either wet etching or dry etching may be applicable, but dry etching suitable for micropatternization is desirable for working of a semiconductor substrate or a mask substrate of high integration degree. In this regard, a crosslinked resist film of particularly excellent etching resistance can be produced by incorporation of benzene rings into the molecular structure of the acetalized polyvinyl alcohol to be used in the present invention. For example, when the patternized film of the thus prepared resist of the present invention is formed on a chromium mask substrate and subjected to dry etching at the exposed chromium portion with a chlorine-containing gas such as carbon tetrachloride, the film reduction speed of the resist film is equal to the value of the photoresist of a novolac type phenol resin which has very excellent dry etching resistance.

The etching conditions are basically known for respective semiconductor or mask substrates to be processed. Examples of etchants to be used in combination with the resist of the invention include dry etchants such as carbon tetrachloride (suitable for Cr masks and Al films), carbon tetrafluoride (for Ta masks, $SiO_2$ films, $Si_3N_4$ and poly-Si films), these gases being used together with a minor amount of oxygen, as desired, and wet etchants such as $(NH_4)_2Ce(NO_3)_6$ dissolved in dilute perchloric acid (for Cr masks) and $AgNo_3 + NH_4F$ dissolved in dilute nitric acid (for $Si + SiO_2$ compound films).

After etching, the resist pattern is removed by peeling off or burning with an oxygen plasma. Thus, one cycle of the lithographic steps is completed.

As described above, according to the present invention, there is provided a negative-type resist sensitive to ionizing radiation which is highly practical and suitable for production of a highly integrated semiconductor circuit or photomask for which dry etching is essentially required for micropatternization, because it has high sensitivity as well as high resolving power and also has excellent dry etching resistance.

In order to indicate fully the nature and utility of this invention, the following examples are set forth, it being understood that these examples are presented as illustrative only and are not intended to limit the scope of the invention.

Example 1

A polyvinyl alcohol (10 g) having a polymerization degree of 1,500 and 150 g (1.4 mole) of benzaldehyde were added to 1,000 $cm^3$ of a solvent mixture of 5:2 (weight ratio) of ethylene chloride and methanol. This step was followed further by addition of 2-3 drops of hydrochloric acid, and the reaction was carried out under stirring at 45 °C for 40 hours. Then, the reaction mixture was placed into methanol, and the precipitated polymer was dissolved in benzene. The polymer was purified by re-precipitation with a solvent mixture of methanol and benzene or obtain an acetalized polyvinyl alcohol of the following formula in a yield of 90%.

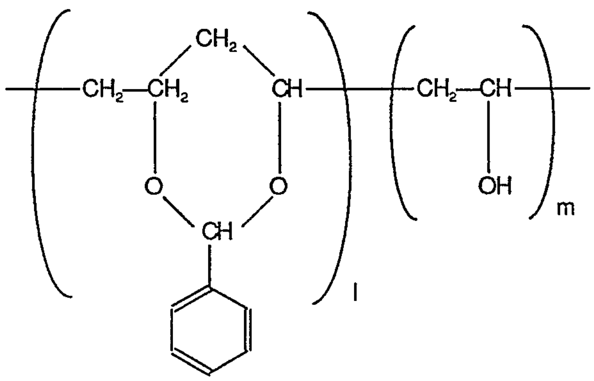

The above polymer had a viscosity of 160 $cm^3/g$ in a benzene solution (0.1 g/10 $cm^3$, 30 °C), from which its molecular weight was estimated to be about 110000. The acetalization percentage $l/(l+m)$ was also found to be about 70 mole%.

The above polymer was dissolved in benzene and filtered through a 0.2 μm filter to obtain a resist solution of 5% concentration.

The resist solution was applied on a chromium mask substrate (blank) by the spinner coating method and pre-baked at 90 °C for 30 minutes to obtain a uniform resist film of a thickness of 600 nm (6,000 Å). Then, on the resist film, an electron beam of a beam radius of 0.25 μm and an energy of 10 KeV was projected in a dose of $2 \times 10^{-6}$ coulomb/$cm^2$ to carry out pattern drawing thereon. Further, the resist film was developed by treatment with benzene for one minute, followed by washing with isopropyl alcohol for one minute, to form a resist pattern.

As the next step, the substrate having the resist pattern obtained was post-baked at 140 °C for 30 minutes and thereafter subjected to the scum-elimination treatment with an oxygen plasma of a pressure of 133 Pa (1 Torr) and an output of 100 W for one minute. The substrate was then subjected to etching at the exposed portion of the chromium film according to the reactive sputter etching method with a gas mixture of $CCl_4$ and $O_2$ under a pressure of 40 Pa ($3 \times 10^{-1}$ Torr) and an output of 300 W for 5 minutes. The film reduction speed of the resist pattern was found to be 20 nm/min (200 Å/min.), thus indicating sufficient dry etching resistance.

After etching, the substrate was immersed in a film-peeling solution of a sulfuric acid-hydrogen peroxide mixture at 70 °C for 5 minutes, and

thereafter the resist pattern film was peeled off to obtain a photomask having a chromium pattern comprising 2 μm lines and spaces.

Example 2

With the use of the same mole (67 g) of acetaldehyde in place of benzaldehyde and the use of a solvent mixture of 7:1 of methanol and water, acetalization of the same polyvinyl alcohol as that used in Example 1 was carried out at 40 °C for 15 hours. The reaction product was filtered and purified similarly as in Example 1 to obtain a polymer of the following formula in a yield of 80%.

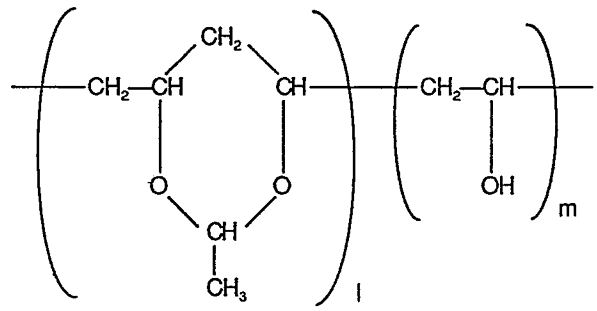

The above polymer had a viscosity of 210 $cm^3/g$ in 0.1 g/10 $cm^3$ methyl cellosolve solution at 30 °C. The estimated molecular weight was 76000, and the acetalization percentage about 68 mole%.

The above polymer was dissolved in methyl cellosolve and filtered to obtain a resist solution of 5% concentration.

The resist solution was applied on a wafer havin a silicon oxide film by the spinner coating method and pre-baked at 80 °C for 30 minutes to form a uniform resist film of a thickness of 1 μm. Then, the resist film was irradiated with an electron beam of an energy of 10 KeV in a dose of $6 \times 10^{-6}/cm^2$ and developed with methyl cellosolve, which step was followed by rinsing with isopropyl alcohol to form a resist pattern.

Subsequently, after performing the post-bake treatment and the scum elimination treatment similarly as in Example 1, wet etching was carried out with a mixed aqueous solution of hydrofluoric acid and ammonium fluoride and the resist film was peeled off to prepare a wafer having a patternized silicon oxide film.

Example 3

With the use of the same mole (130 g) of trimethylsiloxycyclohexane synthesized from cyclohexanone in place of benzaldehyde, after addition of 2-3 drops of hydrochloric acid in dimethyl sulfoxide, the polyvinyl alcohol as used in Example 1 was acetalized at 50 °C for 15 hours to obtain a polymer of the following formula in yield of 95%.

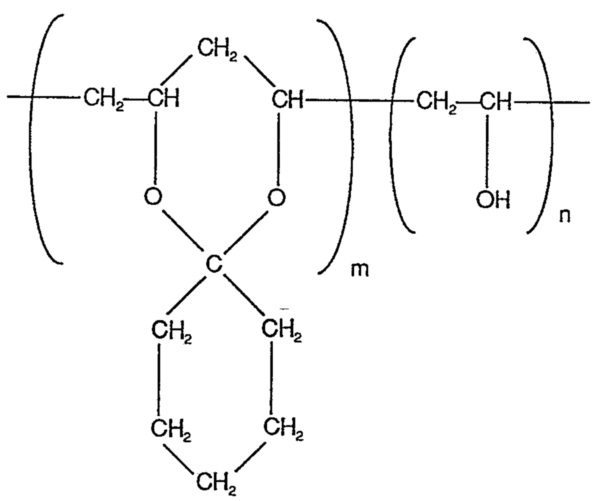

The above polymer had viscosity of 180 $cm^3/g$ in methyl cellosolve solution (0.1 g/10 $cm^3$, 30 °C), the estimated molecular weight being about 89000 and the acetalization percentage being about 42 mole%.

The polymer was dissolved in methyl cellosolve to obtain a 5% resist solution, which was in turn coated and dried. The resist film obtained of a thickness of 0.6 μm was subjected to pattern irradiation by an electron beam of 10 KeV an developed with methyl cellosolve. As the result, it exhibited a sensitivity (dose when the residual film percentage after resist development is 50%) of $4 \times 10^{-6}$ coulomb/$cm^2$.

Example 4

With the use of a saponified product of ethylene/vinyl acetate copolymer (vinyl acetate content: 80%) having a polymerization degree of 1 000 and acetaldehyde, acetalization was conducted by following substantially the same procedure as in Example 2, to obtain an acetalized polymer. The acetalization percentage was 40%, and the polymer had a viscosity of 150 $cm^3/g$ in 0.1 g/10 $cm^3$ methyl cellosolve solution at 30 °C, the estimated molecular weight being about 90 000.

The above polymer was dissolved in methyl cellosolve to prepare an 8% resist solution, which was then applied as a coating and dried. The resist film obtained of a thickness of 0.6 μm was subjected to pattern irradiation by an electron beam of 10 KeV and developed with methyl cellosolve to exhibit a sensitivity of $8 \times 10^{-6}$ coulomb/$cm^2$.

Example 5

Into one liter of a 10.5% methanolic solution of a polyvinyl acetate having a polymerization degree of 1000,0.5 mole of sulfuric acid was added and deacetylation (saponification) was carried out by heating at 60 °C for 40 minutes. Immediately before the mixture became turbid, acetaldehyde was added in a quantity of two equivalents of polyvinyl acetate, and the reaction was carried out at 60 °C for one hour. The reaction product was precipitated by adding it into benzene, the precipitate was dissolved in acetone and the polymer was re-precipitated with a solvent mixture of methanol and benzene to obtain a polymer of the following formula:

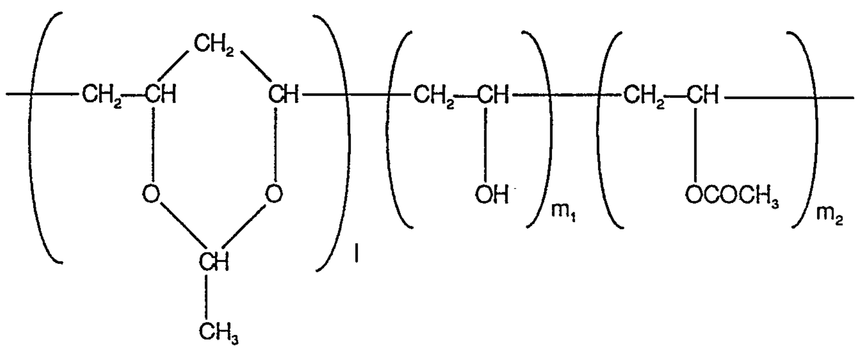

The above polymer had a solution viscosity in methyl cellosolve of 180 $cm^3/g$ (0.1 g/10 $cm^3$, 30 °C), the acetalization percentage $(l/(l+m+n))$ being 25 mole% and the acetyl percentage $(m_2/(l+m_1+m_2))$ being 38%.

The sensitivity measurement was carried out similarly as in Example 3 with the use of a resist solution comprising a 5% methyl cellosolve solution of the above polymer. As a result, the resist film exhibited a sensitivity of $6 \times 10^{-6}$ coulomb/$cm^2$.

Example 6

Two parts of the acetalized polyvinyl alcohol synthesized in Example 1 and one part of a polyvinyl acetate having a polymerization degree of 1 000 were dissolved in chloroform and thoroughly mixed to obtain a resist solution of 6% concentration. The polymeric mixture obtained separately by precipitation and purification was found to have a solution viscosity of 150 $cm^3/g$ (30 °C, 0.1 g/10 $cm^3$ sulfuric acid solution).

Sensitivity measurement was conducted with the use of the above resist solution and chloroform as developer, by following otherwise the same procedure as in Example 3. As a result, the resist film was found to exhibit a sensitivity of $3 \times 10^{-6}$ coulomb/$cm^2$.

Example 7

A polyvinyl alcohol (1.0 g) having a polymerization degree of 2000 and a saponification degree of 98%, 8 g (0.057 mole) of p-chlorobenzaldehyde and 20 $cm^3$ of chloroform were charged into a 50 $cm^3$ Erlenmeyer flask, and, after two drops of hydrochloric acid were added to the mixture, the reaction was carried out under stirring at 40 °C for 50 hours.

Then, the reaction mixture was added into methanol containing a neutralizing amount of NaOH, and the precipitated polymer was purified by repeating reprecipitation with chloroform and methanol to obtain an acetalized alcohol represented by the following formula in a yield of 95%.

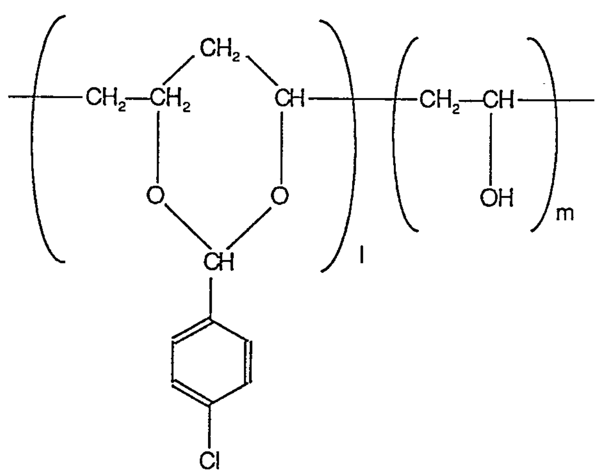

The above polymer had a solution viscosity $\eta_{sp}/c$ (where $\eta_{sp}$ is specific viscosity and c is a concentration [g/$cm^3$]) of 193 $cm^3/g$ in 0.1 g/10 $cm^3$ dichloroethane solution at 30 °C, the molecular weight being estimated to be about 160000-170000. The acetalization percentage $l/(l+m)$ as calculated from the result of elementary analysis was about 73 mole%.

The above polymer was dissolved in ethyl cellosolve acetate and filtered through a 0.2 μm filter to obtain a resist solution of 6% concentration.

The resist solution was applied on a chromium mask substrate by the spinner coating method and pre-baked at 90°C for 30 minutes to obtain a uniform resist film of a thickness of 600 nm (6000 Å). Then, the resist film was irradiated with an electron beam of a beam radius of 0.25 μm and an energy of 10 KeV. After irradiation was effected by varying the dose, development was carried out by immersion in methyl ethyl ketone for 60 seconds and further rinsing by immersion in isopropyl alcohol for 30 seconds. Then, the residual film percentages were plotted versus doses to obtain a sensitivity curve, and the sensitivity was determined as the dose when the film percentage after development is 50%. The resist had a sensitivity of $6.0 \times 10^{-7}$ coulomb/cm$^2$.

Further, with the use of this resist, a resist film of a thickness of 600 nm (6000 Å) was obtained on a chromium mask similarly as described above, and pattern drawing was carried out thereon by the use of an electron beam of a beam radius of 0.5 μm and an acceleration voltage of 10 kV in a dose of $6.0 \times 10^{-7}$ coulomb/cm$^2$. Further, this resist film was developed by treatment with methyl ethyl ketone for one minute, followed by rinsing with isopropyl alcohol for 30 minutes fo form a resist pattern.

As the next step, the substrate having the resist pattern thus obtained was post-baked at 140°C for 30 minutes and thereafter subjected to the scum elimination treatment with an oxygen plasma of a pressure of 133 Pa (1 Torr) an an output of 100 W for one minute. The substrate was then subjected to etching at the exposed portion of the chromium film according to reactive sputter etching with a gas mixture of $CCl_4$ and $O_2$ under a pressure of 40 Pa ($3 \times 10^{-1}$ Torr) and an output of 300 W. The film reduction speed of the resist pattern was found to be 28 nm/min (280 Å/min), thus indicating sufficient dry etching resistance.

After etching, the substrate was immersed in a film-peeling solution of a sulfuric acid-hydrogen peroxide mixture at 70°C for 5 minutes, and thereafter the resist pattern film was peeled off to obtain a photomask having a chromium pattern comprising lines and spaces each of 1 μm.

Example 8

With the use of polyvinyl alcohol having a polymerization degree of 500 and m-bromobenzaldehyde, an acetalized polyvinyl alcohol (molecular weight: about 90000) was synthesized according to the same method as in Example 7.

The resultant polymer was dissolved in ethyl cellosolve acetate and filtered with a 0.2 μm filter to obtain a resist solution of 8% concentration.

The resist solution was applied on a silicon wafer having grown polysilicon of 300 nm (3000 Å) on a silicon oxide film by the spin coating method and pre-baked at 90°C for 30 minutes to obtain a uniform resist film of a thickness of 500 nm (5000 Å). Then, on the resist film, pattern drawing was carried out by irradiation with an electron beam with a beam radius of 0.25 μm and an energy of 10 KeV in a dose of $5.0 \times 10^{-6}$ coulomb/cm$^3$. After drawing, development was carried out by treatment in methyl ethyl ketone for one minute, followed by rinsing with isopropyl alcohol for 30 seconds, to form a resist pattern.

As the next step, the silicon wafer having formed thereon the resist pattern was post-baked at 140°C for 30 minutes and thereafter subjected to the scum elimination with a plasma similarly as in Example 7. Then, dry etching was carried out similarly as in Example 7 with the use of a gas mixture of $CF_4$ with 2% of $O_2$ under the conditions of 267 Pa (2 Torr) and output of 300 W.

After dry etching, the substrate was treated with an oxygen plasma under the conditions of 667 Pa (5 Tor), 300 W to peel off the resist, whereby a pattern of polysilicon having alternately repeated lines of 0.5 μm width and gaps of 0.5 μm width was obtained.

Example 9

After an acetalized polyvinyl alcohol was synthesized similarly as in Example 7 with the use of 4-chloro-1-naphtoaldehyde and a polyvinyl alcohol (polymerization degree: 2000), the resultant acetalized polyvinyl alcohol was dissolved in chlorobenzene to provide a 6% resist solution. The resist solution was applied on a chromium substrate by the spin coating method at a rotational speed of 2500 r.p.m. and pre-baked at 120°C for 30 minutes to obtain a uniform coated film of a thickness of 600 nm (6000 Å). Then, various patterns were drawn on this coated film with the use of an electron beam of 10 KeV energy in various doses. After drawing, development was carried out by immersion in chloroform for 60 seconds, followed by rinsing with isopropyl alcohol by immersion for 30 seconds, to obtain resist patterns. In this Example, the dose for providing a residual film thickness of 50% was found to be $4.5 \times 10^{-6}$ coulomb/cm$^2$.

Next, with the use of the above resist solution, a uniform coated film of a thickness of 400 nm (4000 Å) was formed on a chromium substrate and then pre-baked at 120°C for 30 minutes. Subsequently, pattern drawing was carried out on the coated film with an electron beam of an energy of 10 KeV and a beam radius of 0.5 μm. The irradiated product was subjected to development and rinsing as described above and thereafter post-baked at 140°C for 30 minutes. The chromium substrate having thus formed thereon a resist pattern was subjected do dry etching with a gas mixture of $CCl_4 : O_2 = 3:1$ under the conditions of 40 Pa (0.3 Torr), 300 W, for 8 minutes to obtain a Cr pattern of 1 μm width.

The resist of this Example exhibited high plasma resistance, with a film reduction speed of 15 nm/min (150 Å/min) during the dry etching.

Example 10

According to the same procedure as in Example 7, an acetalized PVA was synthesized from p-chloromethylbenzaldehyde and a PVA (polymerization degree: 2000). The polymer was dissolved in chlorobenzene to prepare a 6% resist solution, which was filtered with a 0.2 μm filter. The thus prepared solution was applied by spin coating at 2500 r.p.m. on a chromium substrate and pre-baked at 120 °C for 30 minutes to obtain a uniform coated film of a thickness of 600 nm (6000 Å). Then, the resist layer was irradiated with an electron beam of an acceleration voltage of 10 kV and a diameter of 0.5 μm so as to obtain a charge density of $8 \times 10^{-7}$ $C/cm^2$. The irradiated product was thereafter developed by immersing in a developer of methyl ethyl ketone: ethanol = 9:1 at a liquid temperature of 20°C for 60 minutes. This step was followed by rinsing with isopropyl alcohol for 30 minutes, to obtain a desired pattern. After post-baking at 140°C for 30 minutes, dry etching was carried out by means of a parallel flat plate type plasma device with a gas mixture of $CCl_4:O_2 = 3:1$ under the conditions of 40 Pa (0.3 Torr) and 300 W for 8 minutes. Then, plasma ashing was carried out with $O_2$ gas under the conditions of 133 PA (1 Torr) and 400 W for 20 minutes. As the result, there was obtained a chromium mask having lines and spaces of 1 μm with good pattern edges.

Other Examples

Acetalization was conducted in the same manner as in Example 7, except for varying the polymerization degree of the polyvinyl alcohol (PVA) as starting materials at 500, 1 500 and 2000 and using as the acetalizing agent in place of p-chlorobenzaldehyde substantially the same moles of cyclohexanone, acetaldehyde, benzaldehyde, m-chlorobenzaldehyde, m-nitrobenzaldehyde, p-methylbenzaldehyde, m-methylbenzaldehyde, o-chlorobenzaldehyde, 2,4-dichlorobenzaldehyde, 2,6-dichlorobenzaldehyde, m-fluorobenzaldehyde, m-bromobenzaldehyde, p-fluorobenzaldehyde, p-bromobenzaldehyde, p-iodobenzaldehyde, benzylaldehyde, 2-methyl-4-chlorobenzaldehyde, and 4-chloronaphthoaldehyde. Acetalized polyvinyl alcohols were also prepared by carrying out the post-treatment.

The thus prepared acetalized polyvinyl alcohols may be represented by the formula:

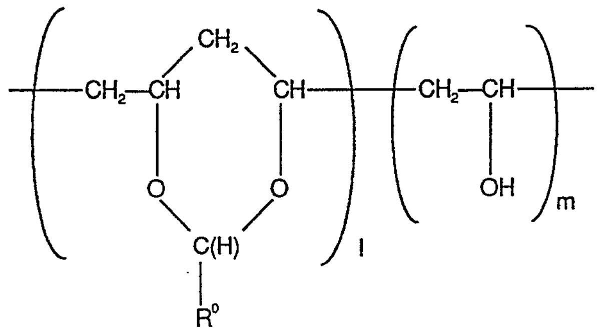

wherein the group $R^0$ corresponds to the groups as shown in Table 1 shown below.

The viscosities $\eta_{sp}/c$ and sensitivities of the sample polymers were determined similarly as in Example 7, and the resolution index (γ) was determined in each case from the gradient of the tangential line at the point of the residual percentage 50% on the sensitivity curve [standardized residual percentage – log (irradiation energy)]. Thus, γ is given by the following equation:

$$\gamma = [\log \frac{Do}{Di}]^{-1}$$

wherein Di and Do are irradiation energy values obtained by extrapolation of th tangential line on the sensitivity curve at the point of residual film percentage of 50% to residual film percentages of 0 and 100% respectively.

The results obtained are listed in Table 1 shown below. In Table 1, the reaction time for synthesis was 40 hours and the coated film thickness was 0.6 μm in all cases.

Table 1

| Group $R^0$ | Sample No. | PVA polymerization degree | Viscosity $\eta_{sp}/c$ | Sensitivity $C/cm^2$ | γ value |
|---|---|---|---|---|---|
| 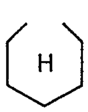 | A–1 | 500 | 89 | $10.5 \times 10^{-6}$ | 1.5 |
| | A–2 | 1500 | 212 | $6.0 \times 10^{-6}$ | 1.1 |
| 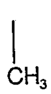 | B–1 | 500 | 82 | $23.0 \times 10^{-6}$ | 1.3 |
| | B–2 | 1500 | 236 | $8.2 \times 10^{-6}$ | 1.3 |
| | B–3 | 2000 | 340 | $6.0 \times 10^{-6}$ | 1.1 |
| 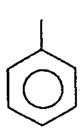 | C–2 | 500 | 80 | $10.0 \times 10^{-6}$ | 1.2 |
| | C–3 | 1500 | 236 | $2.1 \times 10^{-6}$ | 1.1 |

Table 1 (continued)

| Group $R^0$ | Sample No. | PVA polymerization degree | Viscosity $\eta_{sp}/c$ | Sensitivity $C/cm^2$ | $\gamma$ value |
|---|---|---|---|---|---|
| 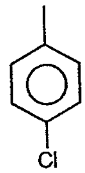 | D–1 | 500 | 66 | $4.0 \times 10^{-6}$ | 1.2 |
| | D–2 | 1500 | 186 | $1.1 \times 10^{-6}$ | 1.2 |
| | D–3 | 2000 | 193 | $0.72 \times 10^{-6}$ | 1.2 |
| 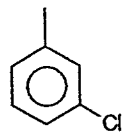 | E–1 | 500 | 63 | $4.5 \times 10^{-6}$ | 1.2 |
| | E–2 | 1500 | 169 | $1.1 \times 10^{-6}$ | 1.1 |
| | E–4 | 2000 | 211 | $0.78 \times 10^{-6}$ | 1.1 |
| 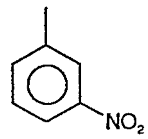 | F–1 | 500 | 50 | $9.8 \times 10^{-6}$ | 1.5 |
| | F–2 | 1500 | 134 | $2.0 \times 10^{-6}$ | 1.4 |
| 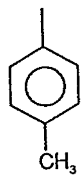 | G–1 | 500 | 79 | $9.8 \times 10^{-6}$ | 1.7 |
| | G–2 | 1500 | 225 | $4.0 \times 10^{-6}$ | 1.0 |
| | G–3 | 2000 | 270 | $2.9 \times 10^{-6}$ | 1.0 |
| 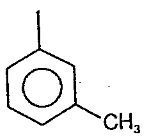 | H–1 | 500 | 68 | $14.0 \times 10^{-6}$ | 1.0 |
| | H–2 | 1500 | 205 | $4.8 \times 10^{-6}$ | 1.0 |
| | H–3 | 2000 | 250 | $3.1 \times 10^{-6}$ | 1.1 |
| 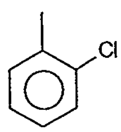 | I–1 | 500 | 55 | $5.2 \times 10^{-6}$ | 1.3 |
| | I–2 | 1500 | 160 | $1.6 \times 10^{-6}$ | 1.3 |
| | I–3 | 2000 | 167 | $1.1 \times 10^{-6}$ | 1.0 |
| 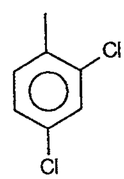 | J–1 | 500 | 47 | $5.8 \times 10^{-6}$ | 1.2 |
| | J–2 | 1500 | 126 | $1.8 \times 10^{-6}$ | 1.3 |
| 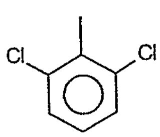 | K–1 | 500 | 37 | $7.8 \times 10^{-6}$ | 1.2 |
| | K–2 | 1500 | 72 | $2.4 \times 10^{-6}$ | 0.9 |
| 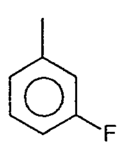 | L–1 | 500 | 61 | $7.0 \times 10^{-6}$ | 0.9 |
| | L–2 | 1500 | 189 | $2.3 \times 10^{-6}$ | 1.4 |
| | L–3 | 2000 | 240 | $1.7 \times 10^{-6}$ | 1.2 |

Table 1 (continued)

| Group $R^0$ | Sample No. | PVA polymerization degree | Viscosity $\eta_{sp}/c$ | Sensitivity $C/cm^2$ | γ value |
|---|---|---|---|---|---|
| 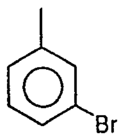 | M-1 | 500 | 50 | $5.0 \times 10^{-6}$ | 1.2 |
| | M-2 | 1500 | 142 | $1.3 \times 10^{-6}$ | 1.2 |
| 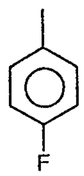 | L-1 | 500 | 68 | $4.7 \times 10^{-6}$ | 1.2 |
| | L-2 | 1500 | 201 | $1.5 \times 10^{-6}$ | 1.3 |
| | L-3 | 2000 | 251 | $1.4 \times 10^{-6}$ | 1.2 |
| 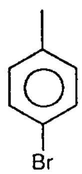 | O-1 | 1500 | 111 | $1.4 \times 10^{-6}$ | 1.1 |
| 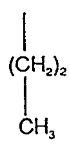 | P-1 | 500 | 52 | $15.0 \times 10^{-6}$ | 1.4 |
| | P-2 | 1500 | 185 | $5.7 \times 10^{-6}$ | 1.2 |
| | P-3 | 2000 | 211 | $3.3 \times 10^{-6}$ | 1.1 |
| 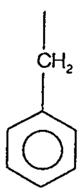 | Q-1 | 500 | 67 | $18.0 \times 10^{-6}$ | 1.4 |
| | Q-2 | 1500 | 169 | $6.4 \times 10^{-6}$ | 1.3 |
| 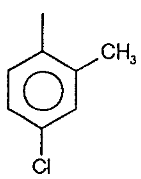 | R-1 | 500 | 75 | $7.2 \times 10^{-6}$ | 1.4 |
| | R-2 | 1500 | 215 | $3 \times 10^{-6}$ | 1.2 |
| | R-3 | 2000 | 275 | $1.1 \times 10^{-6}$ | 1.1 |
| 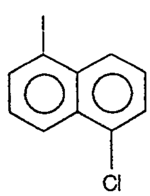 | S-1 | 500 | 60 | $1.1 \times 10^{-6}$ | 1.0 |
| | S-2 | 1500 | 154 | $5.5 \times 10^{-6}$ | 1.0 |

The results shown in the above Table 1 indicate that halogen-containing acetalized polyvinyl alcohols constituting preferred examples of the present invention have substantially higher sensitivities.

Further, dry etching resistance was measured for some of the acetalized polyvinyl alcohols obtained as described above and some commercially available resists. The results are shown in the following Table 2.

Table 2

| Sample No. | Etching Speed (nm/minute) | Remarks |
|---|---|---|
| A-2 | 34 | Example |
| B-2 | 25 | Example |
| C-3 | 25 | Example |
| D-3 | 28 | Example |
| E-4 | 28 | Example |
| J-2 | 30 | Example |
| Commercial resist *1 | 54 | Comparative Example |
| Commercial resist *2 | 39 | Comparative Example |
| Commercial resist *3 | 25 | Comparative Example |

*1) Glycidyl methacrylate type negative-type electron beam resist (OEBR-100, produced by TOkyo Oka Kogyo Co.).

*2) Polymaleic acid monomethyl methacrylate type negative-type electron beam resist (SEL-N, produced by Somar Kogyo Co.).

*3) Novolac type phenol resin type photoresist having quinone diazide (AZ-1350, produced by Shipley Co.).

The results shown in the above Table 2 indicate that the acetalized polyvinyl alcohol of the present invention is an electron beam having ample dry etching resistance.

## Claims

1. A negative-type non-photosensitive resist sensitive to high energy ionizing radiation, which comprises an acetalized polyvinyl alcohol polymer having a molecular weight of 10000 to 1000000 represented by the formula:

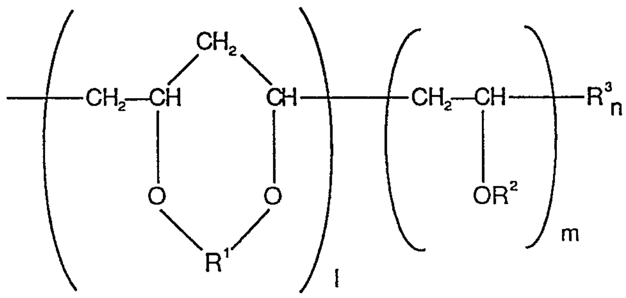

wherein: $R^1$ represents a residue of an aldehyde or a ketone; $R^2$ represents a hydrogen atom, which may partially be substituted by an acetyl group; $R^3$ represents naught or a monomeric unit copolymerizable with vinyl acetate; and , m, n are integers indicating polymerization degrees, the resist being developed with a solvent selected from aromatic hydrocarbons, chlorinated hydrocarbons cellosolves, lower alcohols and mixtures thereof.

2. A negative-type resist according to Claim 1, wherein $R^1$ is a group selected from aliphatic saturated hydrocarbon groups, olefinic hydrocarbon groups, heterocyclic groups and epoxidized hydrocarbon groups.

3. A negative-type resist according to Claim 1, wherein $R^1$ is a halo-containing residue of an aldehyde or a ketone.

4. A negative-type resist according to Claim 3, wherein $R^1$ is a group selected from aliphatic hydrocarbon groups, heterocyclic groups olefinic hydrocarbon groups and epoxidized hydrocarbon groups in which at least one hydrogen atom has been replaced by a halogen.

5. A negative-type resist according to any of Claims 1 to 4, which comprises a mixture of said polyvinyl alcohol polymer with another polymer compatible therewith.

6. A negative-type resist according to Claim 5, wherein said another polymer is selected from polyvinyl acetate, ethylene/vinyl acetate copolymer, styrene/vinyl acetate copolymer and partially saponified products thereof.

7. A negative-type resist according to any of Claims 1 to 6, wherein the acetalized moiety content as represented by $l/(l+m+n)$ in said acetalized polyvinyl alcohol is 20 to 85 mole%.

8. A negative-type resist according to any of Claims 1 to 6, which is in the form of a solution dissolved in a solvent selected from aromatic hydrocarbons, ketones, chlorinated hydrocarbons, and cellosolves.

9. A high energy ionizing radiation lithographic method, which comprises forming on a substrate a thin film of a non-photosensitive resist comprising an acetalized polyvinyl alcohol polymer having a molecular weight of 10000 to 1000000 represented by the formula:

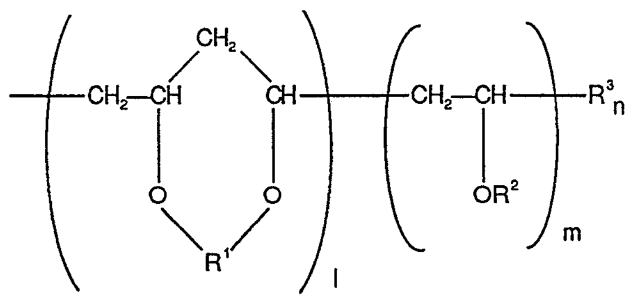

wherein: $R^1$ represents a residue of an aldehyde or a ketone; $R^2$ represents a hydrogen atom, which may partially be substituted with an acetyl group; $R^3$ represents naught or a monomeric unit copolymerizable with vinyl acetate; and l, m, n are integers indicating polymerization degrees, subjecting the thin film of said resist to imagewise irradiation by ionizing radiation, dissolving away selectively the non-irradiated portions of the resist film with a solvent selected from aromatic hydrocarbons, chlorinated hydrocarbons, cellosolves, lower alcohols and mixtures thereof to expose corresponding portions of the substrate, and etching selectively the exposed portions of the substrate.

10. A high energy ionizing lithographic method according to Claim 9, wherein etching is carried out with the use of a gaseous etchant comprising a halogen-containing gas such as carbon tetrachloride and carbon tetrafluoride or a mixture of such a gas with oxygen.

**Patentansprüche**

1. Negativ arbeitender, nicht fotoempfindlicher, gegenüber ionisierender Strahlung hoher Energie empfindlicher Resist, der ein acetylisiertes Polyvenylalkoholpolymer mit einem Molekulargewicht von 10000 bis 1000000 enthält, das durch die folgende Formel dargestellt ist:

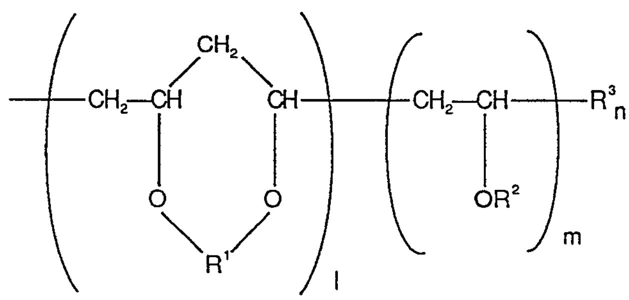

in der: $R^1$ einen Rest eines Aldehyds oder eines Ketons darstellt; $R^2$ ein Wasserstoffatom darstellt, das partiell durch eine Acetylgruppe ersetzt sein kann; $R^3$ «Null» oder eine mit Venylacetat polymerisierbare monomere Einheit darstellt und l, m, n ganze Zahlen sind, welche die Polymerisationsgrade angeben, und der mit einem Lösungsmittel entwickelt wird, das aus aromatischen Kohlenwasserstoffen, chlorierten Kohlenwasserstoffen, niederen Alkoholen und Mischungen daraus ausgewählt ist.

2. Negativ arbeitender Resist nach Anspruch 1, dadurch gekennzeichnet, dass $R^1$ eine aus aliphatisch gesättigten Kohlenwasserstoffgruppen, olefinischen Kohlenwasserstoffgruppen, heterozyklischen Gruppen und epoxydierten Kohlenwasserstoffgruppen ausgewählte Gruppe ist.

3. Negativ arbeitender Resist nach Anspruch 1, dadurch gekennzeichnet, dass $R^1$ ein halogenhaltiger Rest eines Aldehyds oder eines Ketons ist.

4. Negativ arbeitender Resist nach Anspruch 3, dadurch gekennzeichnet, dass $R^1$ eine aus aliphatischen Kohlenwasserstoffgruppen, olefinischen Kohlenwasserstoffgruppen, heterozyklischen Gruppen und epoxydierten Kohlenwasserstoffgruppen ausgewählte Gruppe ist, in der wenigstens ein Wasserstoffatom durch ein Halogen ersetzt ist.

5. Negativ arbeitender Resist nach einem oder mehreren der Ansprüche 1-4, dadurch gekennzeichnet, dass er eine Mischung aus dem Polyvenylalkoholpolymer mit einem damit verträglichen anderen Polymer enthält.

6. Negativ arbeitender Resist nach Anspruch 5, dadurch gekennzeichnet, dass das andere Polymer aus Polyvenylacetat, Äthylen/Venylacetatcopolymer, Styrol/Venylacetatcopolymer und deren partiell verseiften Produkten ausgewählt ist.

7. Negativ arbeitender Resist nach einem oder mehreren der Ansprüche 1-6, dadurch gekennzeichnet, dass der Gehalt an acetalisierten Gruppen, der in dem acetalisierten Polyvenylalkohol durch $l/(l+m+n)$ dargestellt ist, 20-85 mol% beträgt.

8. Negativ arbeitender Resist nach einem oder mehreren der Ansprüche 1-6, dadurch gekennzeichnet, dass er sich in der Form einer in einem

Lösungsmittel aufgelösten Lösung befindet, wobei das Lösungsmittel aus aromatischen Kohlenwasserstoffen, Ketonen, chlorierten Kohlenwasserstoffen und Cellosolven ausgewählt ist.

9. Lithografisches Verfahren unter Verwendung von ionisierender Strahlung hoher Energie, dadurch gekennzeichnet, dass auf einem Substrat ein dünner Film aus einem nicht fotoempfindlichen Resist gebildet wird, der ein acetalisiertes Polyvenylalkoholpolymer mit einem Molekulargewicht von 10000 bis 1000000 enthält, das durch folgende Formel dargestellt ist:

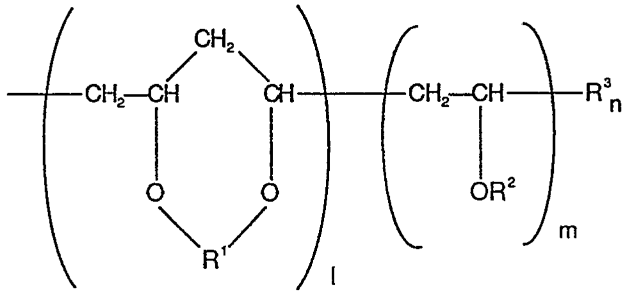

in der: $R^1$ einen Rest eines Aldehyds oder eines Ketons darstellt; $R^2$ ein Wasserstoffatom darstellt, das partiell durch eine Acethylgruppe ersetzt sein kann; $R^3$ «Null» oder eine mit Venylacetat polymerisierbare monomere Einheit darstellt, und l, m, n ganze Zahlen sind, welche die Polymerisationsgrade angeben, dass der dünne Film aus dem Resist einer bildweisen Bestrahlung durch eine ionisierende Strahlung ausgesetzt wird, dass die nicht bestrahlten Teile des Resistfilms mit einem Lösungsmittel, das aus aromatischen Kohlenwasserstoffen, chlorierten Kohlenwasserstoffen, niederen Alkoholen und Mischungen daraus ausgewählt ist, selektiv aufgelöst werden, um entsprechende Teile des Substrats freizulegen, und dass die freigelegten Teile des Substrats selektiv geätzt werden.

10. Lithografisches Verfahren unte Verwendung von ionisierender Strahlung hoher Energie nach Anspruch 9, dadurch gekennzeichnet, dass das Ätzen unter Verwendung eines gasförmigen Ätzmittels ausgeführt wird, das ein halogenhaltiges Gas, wie Kohlenstoff-Tetrachlorid und Kohlenstoff-Tetrafluorid oder eine Mischung eines solchen Gases mit Sauerstoff, enthält.

**Revendications**

1. Agent de réserve non photosensible du type négatif sensible aux radiations ionisantes à grande énergie, qui comprend un polymère d'alcool polyvinylique acétalisé ayant un poids moléculaire de 10000 à 1000000 représenté par la formule:

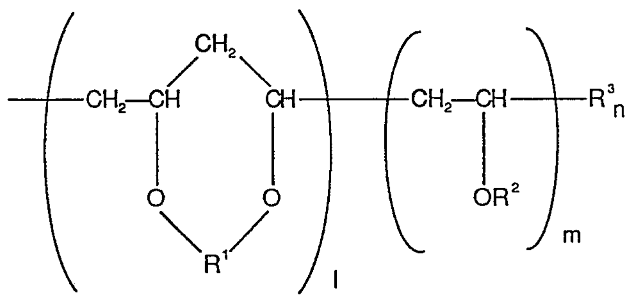

dans laquelle $R^1$ représente le résidu d'un aldéhyde ou d'une cétone; $R^2$ représente un atome d'hydrogène qui peut être partiellement substitué par un groupe acétyle; $R^3$ représente zéro ou un motif monomère copolymérisable avec l'acétate de vinyle; et l, m et n sont des entiers indiquant des degrés de polymérisation, l'agent de réserve étant développé avec un solvant choisi parmi les hydrocarbures aromatiques, les hydrocarbures chlorés, les cellosolves, les alcools inférieurs et les mélanges de ceux-ci.

2. Agent de réserve du type négatif selon la revendication 1, dans lequel $R^1$ est un groupe choisi parmi les groupes hydrocarbures saturés aliphatiques, les groupes hydrocarbures oléfiniques, les groupes hétérocycliques et les groupes hydrocarbures époxydés.

3. Agent de réserve du type négatif selon la revendication 1, dans lequel $R^1$ est un résidu halogéné d'un aldéhyde ou d'une cétone.

4. Agent de réserve du type négatif selon la revendication 3, dans lequel $R^1$ est un groupe choisi parmi les groupes hydrocarbures aliphatiques, les groupes hydrocarbures oléfiniques, les groupes hétérocycliques et les groupes hydrocarbures époxydés dans lequels au moins un atome d'hydrogène a été remplacé par un halogène.

5. Agent de réserve du type négatif selon l'une quelconque des revendications 1 à 4, qui comprend un mélange dudit polymère d'alcool polyvinylique avec un autre polymère compatible avec celui-ci.

6. Agent de réserve du type négatif selon la revendication 5, dans lequel ledit autre polymère

est choisi parmi l'acétate de polyvinyle, les copolymères éthylène-acétate de vinyle, les copolymères styrène-acétate de vinyle et leurs produits de saponification partielle.

7. Agent de réserve du type négatif selon l'une quelconque des revendications 1 à 6, dans lequel la teneur en motifs acétalisés représentée par $l/(l+m+n)$ dans ledit alcool polyvinylique acétalisé est de 20 à 85 mol%.

8. Agent de réserve du type négatif selon l'une quelconque des revendications 1 à 6, qui est sous la forme d'une solution dans un solvant choisi parmi les hydrocarbures aromatiques, les cétones, les hydrocarbures chlorés et les cellosolves.

9. Technique lithographique par radiations ionisantes à grande énergie qui comprend la formation sur un substrat d'un film mince d'un agent de réserve non photosensible comprenant un polymère d'alcool polyvinylique acétalisé ayant un poids moléculaire de 10000 à 1000000, représenté par la formule:

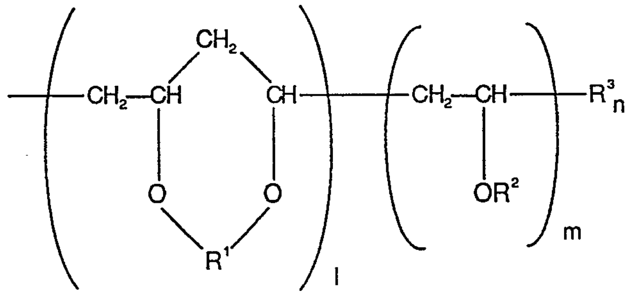

dans laquelle $R^1$ représente und résidu d'un aldéhyde ou d'une cétone; $R^2$ représente un atome d'hydrogène qui peut être partiellement substitué par un groupe acétyle; $R^3$ représente zéro ou un motif monomère copolymèrisable avec l'acétate de vinyle et l, m et n sont des entiers indiquant des degrés de polymérisation, l'irradiation suivant une image du film mince dudit agent de réserve au moyen de radiations ionisantes, la dissolution sélective des portions non irradiées du film d'agent de réserve par un solvant choisi parmi les hydrocarbures aromatiques, les hydrocarbures chlorés, les cellosolves, les alcools inférieurs et leurs mélanges pour exposer les portions correspondantes du substrat et l'incision sélective des portions exposées du substrat.

10. Technique lithographique ionisante à grande énergie selon la revendication 9, dans laquelle l'incision est mise en œuvre avec utilisation d'un agent d'incision gazeux comprenant un gaz halogéné, tel que tétrachlorure de carbone et tétrafluorure de carbone, ou un mélange de ce gaz avec l'oxygène.